# EUROPÄISCHE PATENTANMELDUNG

(11) **EP 4 432 777 A1**
(43) Veröffentlichungstag der Anmeldung: **18.09.2024**
(21) Anmeldenummer: 24158100.8
(22) Anmeldetag: 16.02.2024
(51) Int. Cl.: H05B 3/06, F24H 3/04, F24H 9/1818, F24H 9/1863, H01R 4/48, H01R 12/57, H01R 12/58, H01R 12/71, H01R 12/91

(54) **ELEKTRISCHE HEIZVORRICHTUNG UND ANORDNUNG AUS EINER LEITERPLATTE UND EINEM ANSCHLUSSSTÜCK**

(30) Priorität: 17.02.2023 DE 102023104034
(71) Anmelder: Eberspächer catem GmbH & Co. KG, 76863 Herxheim (DE)
(72) Erfinder: Niederer, Michael, 76889 Kapellen-Drusweiler (DE)
(74) Vertreter: Grünecker Patent- und Rechtsanwälte PartG mbB

(57) **Zusammenfassung**

Um eine elektrische Heizvorrichtung anzugeben, die einen verbesserten elektrischen Anschluss der elektrischen Heizeinrichtung (23) erlaubt, kann sich die elektrische Heizvorrichtung, die wenigstens eine elektrische Heizeinrichtung (23) und eine Leiterplatte (40) aufweist, welche zum elektrischen Anschluss der elektrischen Heizeinrichtung (23) elektrisch leitend mit zumindest einem Anschlussstück (62) verbunden ist, das zumindest einen auf der Leiterplatte (40) anliegenden Befestigungsabschnitt (72) ausbildet, von dem wenigstens zwei Haltestege (74) abragen, die jeweils in einem an der Leiterplatte (40) ausgesparten Befestigungsloch (70) im Eingriff sind, dadurch auszeichnen, dass das Anschlussstück (62) zumindest zwei über einen Verbindungsabschnitt (80) elastisch miteinander verbundene Befestigungsabschnitte (72) ausbildet, die jeweils einen der Haltestege (74) aufweisen, und derart vorgespannt ist, dass die Haltestege (74) der Befestigungsabschnitte (72) mit entgegen gerichteten Haltekräften (86) gegen eine Innenwand (84) des ihnen zugeordneten Befestigungsloches (70) wirken.

## Beschreibung

Die vorliegende Erfindung betrifft eine elektrische Heizvorrichtung mit wenigstens einer elektrischen Heizeinrichtung, die Wärme erzeugt und in der Regel mit elektrischen Anschlüssen, beispielsweise in Form von Kontaktblechen versehen ist, um den Leistungsstrom in die elektrische Heizeinrichtung einzuleiten und die unterschiedlichen Polaritäten zugeordnet sind. Die elektrische Heizvorrichtung hat eine Leiterplatte zum elektrischen Anschluss der elektrischen Heizeinrichtung.

Eine solche Leiterplatte kann verschiedene PTC-Heizelemente der elektrischen Heizvorrichtung zu Heizkreisen gruppieren, wie dies aus EP 3 334 243 A1 bzw. DE 20 2019 005 223 U1 bekannt ist. Die Leiterplatte kann auch mit Bauteilen bestückt sein, um den Leistungsstrom zu dem wenigstens einen PTC-Heizelement zu schalten bzw. zu steuern. Elektrisch leitend mit der Leiterplatte ist ein Anschlussstück zur Steckkontaktierung einer der Kontaktbleche verbunden, das bei der vorliegenden Erfindung nur eine Kontaktzunge für die Steckkontaktierung oder auch eine Kontaktfläche ausbilden kann, die flächig und elektrisch leitende an einer Fläche des PTC-Elementes anliegen kann. Die Fläche des keramischen PTC-Elementes ist auch bei der vorliegenden Erfindung in der Regel mit einer Metallisierung versehen. Das Anschlussstück bildet zumindest einen auf der Leiterplatte anliegenden Befestigungsabschnitt aus, von dem zumindest zwei Haltestege abragen, die jeweils in einem an der Leiterplatte ausgesparten Befestigungsloch im Eingriff sind; vergleiche EP 2 236 330 A1.

Bei der erfindungsgemäßen elektrischen Heizvorrichtung kann die Leiterplatte mit dem Anschlussstück dazu dienen, einen Leistungsschalter zum elektrischen Anschluss der elektrischen Heizeinrichtung elektrisch anzuschließen, unterschiedliche Leiterplatten elektrisch miteinander zu verbinden und/oder die elektrische Heizeinrichtung über die Leiterplatte elektrisch anzuschließen, insbesondere mehrere elektrische Heizeinrichtungen zu Heizkreisen zu gruppieren.

Die erfindungsgemäße elektrische Heizvorrichtung kommt insbesondere in einem Kraftfahrzeug zum Einsatz. Die elektrische Heizvorrichtung unterliegt dementsprechend erheblichen Vibrationsbelastungen über die Lebensdauer der elektrischen Heizvorrichtung. Das Fahrzeug ist unterschiedlichen Temperaturbereichen ausgesetzt. So kann es zu nicht unerheblichen Wärmespannungen kommen, die auch im Inneren der elektrischen Heizvorrichtung auftreten.

Die elektrische Heizeinrichtung der erfindungsgemäßen elektrischen Heizvorrichtung wird insbesondere durch eine PTC-Heizeinrichtung mit zumindest einem PTC-Element und Kontaktblechen zur Bestromung des PTC-Elements mit unterschiedlicher Polarität gebildet. Alternativ kann die elektrische Heizeinrichtung durch ein Dickschicht-Heizelement gebildet sein Dieses besteht in der Regel aus einem Metallkern, auf den verschiedene Schichten aufgebracht sind, die isolierende, resistive und leitfähige Eigenschaften besitzen.

Die vorliegende Erfindung will eine elektrische Heizvorrichtung der eingangs genannten Art angeben, die einen verbesserten elektrischen Anschluss der elektrischen Heizeinrichtung erlaubt.

Zur Lösung dieses Problems wird mit der vorliegenden Erfindung vorgeschlagen, das Anschlussstück mit zumindest zwei Befestigungsabschnitten auszubilden, die über zumindest einen Verbindungsabschnitt elastisch miteinander verbunden sind. Das Anschlussstück der elektrischen Heizvorrichtung bildet dementsprechend zumindest zwei üblicherweise flächig auf der Leiterplatte anliegende Befestigungsabschnitte aus. Diese sind elastisch über den Verbindungsabschnitt miteinander verbunden, und in der Regel derart vorgespannt, dass der einem der Befestigungsabschnitte zugeordnete Haltesteg jeweils unter Vorspannung gegen die Leiterplatte angelegt wird. Der Verbindungsabschnitt erzeugt dabei die beiden Befestigungsabschnitte voneinander weg bzw. aufeinander zu drängenden elastischen Kräfte, die über die jeweiligen Haltestege an der Leiterplatte widergelagert werden. Die Stege können sich lediglich am Umfang des Befestigungsloches elastisch abstützen. Bereits hierdurch wird eine erhöhte Haltekraft bewirkt, über welche das Anschlussstück in verbesserter Weise an der Leiterplatte gehalten und dementsprechend der elektrische Anschluss über das entsprechende Anschlussstück verbessert ist bzw. wird.

Die elastische Vorspannkraft kann die beiden Haltestege aufeinander zu bzw. voneinander weg vorgespannt ausrichten. Die Befestigungslöcher und die darin aufgenommenen Haltestege setzen dieser elastischen Vorspannkraft eine Gegenkraft entgegen, durch welche das Anschlussstück vorgespannt an der Leiterplatte gehalten ist.

Ergänzend oder zusätzlich können weitere Maßnahmen vorgesehen sein, das Anschlussstück mit der Leiterplatte zu verbinden. So kann insbesondere das Anschlussstück elektrisch leitend mit der Leiterplatte verlötet sein.

Das elektrische Anschlussstück hat üblicherweise Federzungen, die in eine weitere Ausnehmung der Leiterplatte hineinragen und die der Steckkontaktierung mit einem anderen Element der elektrischen Heizvorrichtung dienen. Bei diesem anderen Element kann es sich beispielsweise um Kontaktzungen handeln, die dem elektrischen Anschluss einer spezifischen, die Kontaktzunge aufweisenden elektrischen Heizeinrichtung an die Leiterplatte dienen. Auch können Pins eines Leistungsschalters über das Anschlussstück elektrisch mit der Leiterplatte verbunden sein, indem ein Pin zwischen die Federzungen und in die Ausnehmung eingebracht ist. Die Federzungen liegen dabei unter elastischer Vorspannung an dem Pin bzw. der Kontaktzunge an.

Vorzugsweise wirken die Haltestege gegen jeweils eine Innenwand der Befestigungslöcher. Auf diese Weise kann die erforderliche Haltekraft erzeugt werden, um das Anschlussstück an die Leiterplatte zu befestigen und betriebssicher zu halten. Kumulativ oder alternativ kann so das Anschlussstück auch elektrisch mit der Leiterplatte verbunden werden. Wenn die Haltestege jeweils gegen die Innenwand eines anderen Befestigungsloches wirken, kann das Anschlussstück besonders vorteilhaft ausgestaltet sein, sodass über eine elastische Vorspannung dieses betriebssicher an der Leiterplatte befestigt werden kann und eine Anschlussstelle, vorzugsweise an einer Ausnehmung in der Leiterplatte, für einen Leistungsschalter bereitstellen kann. In einer bevorzugten Ausführungsform ist eine entsprechende Ausnehmung in der Leiterplatte zwischen zwei Befestigungslöchern angeordnet, gegen deren Innenwände die beiden Haltestege wirken.

Es ist vorteilhaft, wenn der Verbindungsabschnitt zumindest teilweise bogenförmig ausgebildet ist, um die beiden Befestigungsabschnitte elastisch miteinander zu verbinden. Eine elastische Vorspannung der beiden Befestigungsabschnitte über den bogenförmigen Verbindungsabschnitt kann in unterschiedlichen Vorspannrichtungen erfolgen. Je nachdem in welche Richtung die Vorspannung erfolgt, sind die beiden Haltekräfte zueinander hin oder voneinander weg gerichtet. Dies bedeutet auch, dass die beiden Haltestege entweder gegen die jeweils äußeren Innenwände der Befestigungslöcher wirken, die Haltekräfte also nach außen gerichtet sind. Oder die beiden Haltestege wirken gegen die jeweils inneren Innenwände der Befestigungslöcher, die Haltekräfte sind also nach innen gerichtet. Im Vorliegenden Zusammenhang kann unter "nach außen" vorzugsweise verstanden werden, dass die Haltekräfte voneinander weg gerichtet sind und entsprechend unter "nach innen", dass die Haltekräfte zueinander hin gerichtet sind.

Vorteilhafterweise bildet die Leiterplatte wenigstens eine Ausnehmung und das Anschlussstück zumindest zwei an gegenüberliegenden Seiten in die Ausnehmung hineinragende Federzungen aus, wobei sich zumindest zwei Federzungen genau gegenüberliegen. Hierdurch kann zum elektrischen Anschluss eine entsprechende Kontaktzunge bzw. Pin betriebssicher mit den Federzungen elektrisch verbunden sein. Darüber hinaus kann über die genau gegenüberliegenden Federzungen und einem dazwischen angeordneten Pin bzw. eine dazwischen angeordnete Kontaktzunge auch eine mechanische Verbindung zwischen diesen Elementen erzeugt werden. Vorzugsweise sind die Federzungen elastisch ausgebildet. Wenn eine Kontaktzunge bzw. ein Pin zwischen die Federzungen angeordnet und mit diesen elektrisch und mechanisch verbunden sind, sind die Federzungen derart vorgespannt, dass diese mit entgegen gerichteten Haltekräften gegen die Kontaktzunge bzw. den Pin wirken.

Es ist denkbar, dass durch die Vorspannung der Federzungen, die durch die Aufnahme der Kontaktzunge bzw. des Pins erzeugt wird, auch die Befestigungsabschnitte entsprechende Kräfte erfahren. Das Anschlussstück umfasst sowohl die Federzungen als auch die Befestigungsabschnitte, sodass die Haltekräfte zwischen den Federzungen und der Kontaktzunge bzw. dem Pin auch zumindest teilweise in die Befestigungsabschnitte geleitet werden. Dabei können die Federzungen derart stabil ausgebildet sein, dass die durch die Vorspannung der Federzungen erzeugten Kräfte groß genug sind, um wesentlich die Haltekräfte zwischen den Haltestegen und den Innenwänden der Befestigungslöcher zu beeinflussen. Durch die Konstruktion der vorliegenden Ausführungsform, wirkt die Vorspannung der Federzungen derart auf die Befestigungsabschnitte und somit auch auf die Haltestege, sodass die beiden Haltestege nach außen bzw. voneinander weg gerichtete Kräfte aufnehmen. Durch die Aufnahme der Kontaktzunge bzw. des Pins durch die Federzungen können also die Haltekräfte zwischen Haltestege und Befestigungslöcher verstärkt werden.

Aus diesem Grund ist eine Ausführungsform besonders vorteilhaft, bei welcher das Anschlussstück derart vorgespannt ist, dass die beiden Haltestege mit voneinander weg gerichteten Haltekräften gegen eine Innenwand des ihnen zugeordneten Befestigungsloches wirken. In diesem Fall würden die Haltekräfte in die gleiche Richtung wirken, wie die Kräfte, die die Haltestege jeweils durch die Vorspannung der Federzungen erfahren. So kann vorzugsweise die Gesamthaltekraft, die zwischen Haltestege und Innenwand des Befestigungsloches wirkt, verstärkt werden. Der mechanische Halt des Anschlussstückes in der Leiterplatte kann demnach über die Vorspannung der Federzungen bei Aufnahme einer Kontaktzunge bzw. eines Pins verbessert werden.

Vorzugsweise ragen die Federzungen zwischen zwei Bogen in die Ausnehmung hinein. Zum einen können durch die zwei Bogen die beiden Befestigungsabschnitte elastisch miteinander verbunden werden. Zum anderen kann über den Bereich zwischen den beiden Bogen eine Kontaktzunge bzw. ein Pin von den Federzungen aufgenommen werden. Die Kontaktzunge bzw. der Pin können in die Ausnehmung hineingesteckt werden, ohne dabei mit dem Verbindungsabschnitt zu kollidieren.

Um das Anschlussstück auf besonders einfache Weise bereitzustellen, ist dieses vorzugsweise einstückig aus einem stanz- und biegebearbeitetem Blechstück ausgebildet.

Um eine elektrische Heizvorrichtung der eingangs genannten Art anzugeben, die einen verbesserten elektrischen Anschluss der elektrischen Heizeinrichtung erlaubt, wird kumulativ oder alternativ eine Anordnung aus einer Leiterplatte und einem Anschlussstück vorgeschlagen. Die Leiterplatte ist elektrisch leitend mit dem Anschlussstück verbunden und das Anschlussstück bildet zumindest einen auf der Leiterplatte anliegenden Befestigungsabschnitt aus. Von diesem ragen zumindest zwei Haltestege ab, die jeweils in einem an der Leiterplatte ausgesparten Befestigungsloch im Eingriff sind. Die Anordnung zeichnet sich dadurch aus, dass das Anschlussstück zumindest zwei über einen Verbindungsabschnitt elastisch miteinander verbundene Befestigungsabschnitte ausbildet, die jeweils einen der Haltestege aufweisen. Die Befestigungsabschnitte sind derart vorgespannt, dass die Haltestege der Befestigungsabschnitte mit entgegen gerichteten Haltekräften gegen eine Innenwand des ihnen zugeordneten Befestigungsloches wirken.

Vorteilhafterweise ist der Haltesteg elektrisch mit der Leiterplatte verbunden, sodass eine elektrische Verbindung zwischen dem Anschlussstück und der Leiterplatte auf besonders einfache Weise erfolgen kann. Üblicherweise wird der Haltestege mit der Leiterplatte verlötet.

Es versteht sich, dass die Merkmale der vorstehend bzw. in den Ansprüchen beschriebenen Lösungen gegebenenfalls auch kombiniert werden können, um die Vorteile entsprechend kumuliert umsetzen zu können.

Weitere Einzelheiten und Vorteile der vorliegenden Erfindung ergeben sich aus der nachfolgenden Beschreibung eines Ausführungsbeispiels in Verbindung mit der Zeichnung. In dieser zeigen:
- Figur 1: eine perspektivische Seitenansicht eines Ausführungsbeispiels einer elektrischen Heizvorrichtung mit der Heizkammer nach oben;
- Figur 2: eine perspektivische Ansicht des Ausführungsbeispiels nach Figur 1 mit der Heizkammer nach unten;
- Figur 3: eine Querschnittsansicht des Gehäuseoberteils des Ausführungsbeispiels nach den Figuren 1 und 2;
- Figur 4: eine perspektivische anschlusskammerseitige Draufsicht des Ausführungsbeispiels;
- Figur 5: eine perspektivische Ansicht eines elektrisch mit der Leiterplatte verbundenen Leistungsschalters des Ausführungsbeispiels;
- Figur 6: eine perspektivische Ansicht eines Anschlussstückes des Ausführungsbeispiels;
- Figur 7: eine schematische Seitenansicht einer Anordnung aus einer Leiterplatte und einem Anschlussstück des Ausführungsbeispiels;
- Figur 8: eine schematische Seitenansicht einer Anordnung aus einer Leiterplatte und einem Anschlussstück eines weiteren Ausführungsbeispiels; und
- Figur 9: eine perspektivische Ansicht einer Anordnung aus einer Leiterplatte und einem Anschlussstück eines weiteren Ausführungsbeispiels.

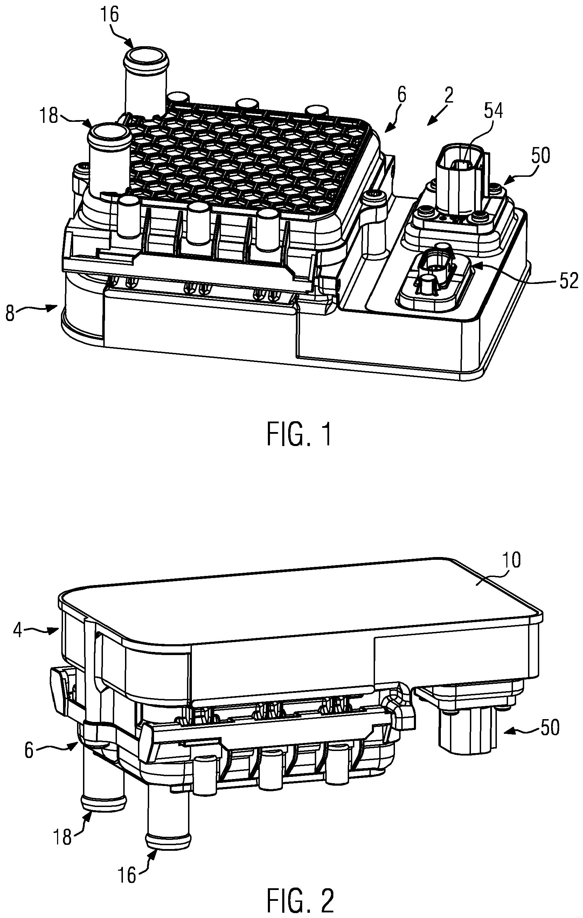

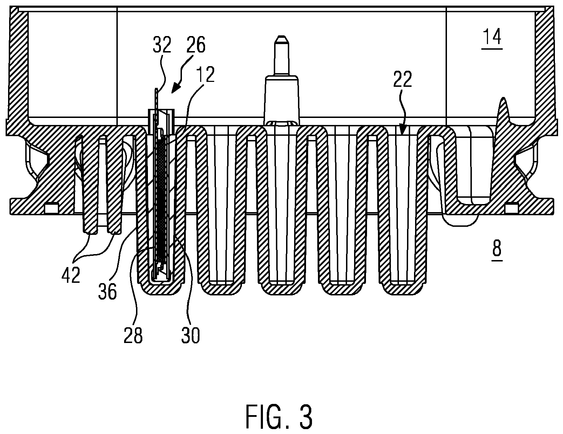

Die Figuren 1 bis 3 zeigen eine Heizvorrichtung mit einem insgesamt mit Bezugszeichen 2 gekennzeichneten Gehäuse. Das Gehäuse 2 hat ein Gehäuseoberteil 4 aus Metall, ein Gehäuseunterteil 6 aus Kunststoff, welches fluiddicht zur Ausformung einer Heizkammer 8 mit dem Gehäuseoberteil 4 verbunden ist und einen Gehäusedeckel 10, der fluiddicht mit dem Gehäuseoberteil 4 verbunden ist. Die Heizkammer ist in Figur 3 mit Bezugszeichen 8 gekennzeichnet, wenngleich das Gehäuseunterteil 6 dort nicht dargestellt ist. Zwischen dem Gehäusedeckel 10 und einer mit Bezugszeichen 12 gekennzeichneten Trennwand bildet das Gehäuseoberteil 4 eine Anschlusskammer 14 aus. Die Trennwand 12 trennt die Anschlusskammer 14 vom der Heizkammer 8 ab.

Das Gehäuseunterteil 6 bildet einen einteilig daran angeformten Einlassstutzen 16 und einen einteilig daran angeformten Auslassstutzen 18 aus. An diese Stutzen 16, 18 können Schläuche zum Führen des zu erwärmenden flüssigen Mediums angeschlossen werden.

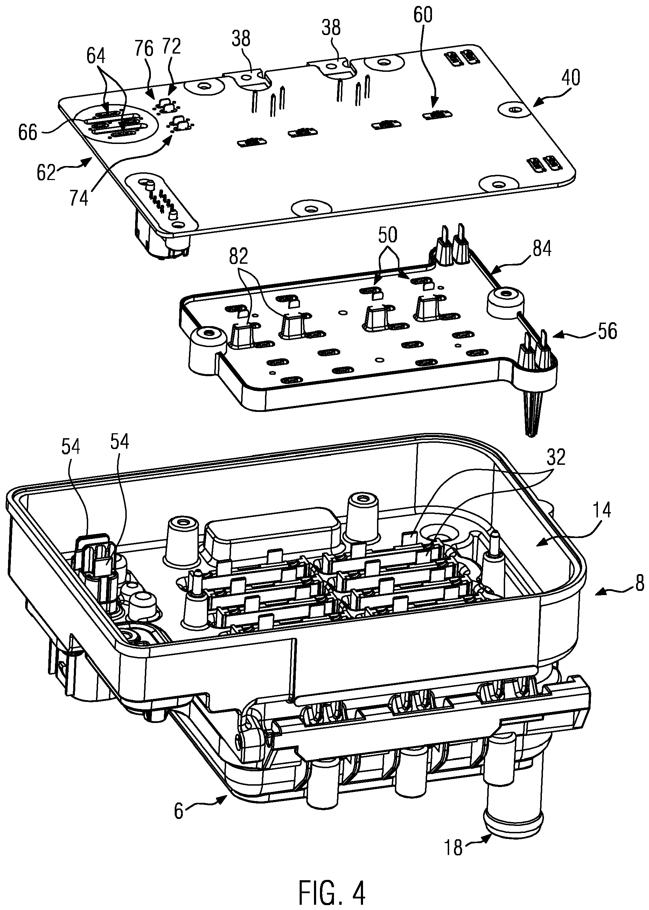

Die Stutzen 16, 18 münden in die Heizkammer 8. In diese Heizkammer 8 ragen Heizrippen 20 hinein. Jede Heizrippe 20 wird durch die Wände einer in Figur 4 mit Bezugszeichen 22 gekennzeichneten Aufnahmetasche gebildet, die zu der Heizkammer 8 hin geschlossen und zu der Anschlusskammer 14 hin offen ist.

In jeder Aufnahmetasche 22 sind vorliegend zwei elektrische Heizeinrichtungen 23 in Form von PTC-Heizeinrichtungen 24 vorgesehen. Jede PTC-Heizeinrichtung 24 hat einen Rahmen 26, der ein PTC-Element 28 in sich aufnimmt und wenigstens zwei Leiterbahnen in Form von Kontaktblechen 30 zu einer Einheit fügt, die unmittelbar elektrisch leitend an Hauptseitenflächen des PTC-Elementes 28 anliegen und bis in die Anschlusskammer 14 hineinragende Kontaktzungen 32 ausbilden. Die Kontaktbleche 30 sind außenseitig mit einer Isolierlage 34, beispielsweise einer Aluminiumoxidplatte bzw. einer elektrisch isolierenden Folie, versehen. Dadurch werden die Kontaktbleche 30 isolierend in der Aufnahmetasche 22 abgestützt. Ein gut wärmeleitender Kontakt der Hauptseitenflächen des PTC- Elementes 28 kann beispielsweise durch Verkeilen des PTC-Elementes 28 zusammen mit den Kontaktblechen und den Isolierlagen 34 in der Aufnahmetasche 22 erfolgen; vergleiche die DE 10 2019 216 481 A1.

In Figur 4 ist seitlich neben den Aufnahmetaschen 22 eine Kühlfläche 36 erkennbar, die durch die Trennwand 12 ausgebildet ist und gegen welche in Figur 3 nur schematisch angedeutete Leistungsschalter 38 wärmeleitend angelegt sind. Diese Leistungsschalter 38 sind auf einer bestückten Steuerleiterplatte 40 montiert und unter Zwischenlage einer Kapton-Folie gegen die durch das Gehäuseoberteil 4 gebildete Kühlfläche 36 angelegt. Diese bestückte Steuerleiterplatte 40 bildet den wesentlichen Teil einer Steuervorrichtung 44 aus. Die Kühlfläche 36 ist wärmeleitend mit der Heizklammer 8 verbunden. Die Figur 1 lässt einen Leistungsstecker 50 und einen Steuerstecker 52 erkennen, die jeweils mit der bestückten Leiterplatte 40 elektrisch kontaktiert sind. Die elektrische Kontaktierung von männlichen Steckkontaktelementen 54 des Leistungssteckers 50 erfolgt unmittelbar durch Steckkontaktierung innerhalb der bestückten Leiterplatte 50.

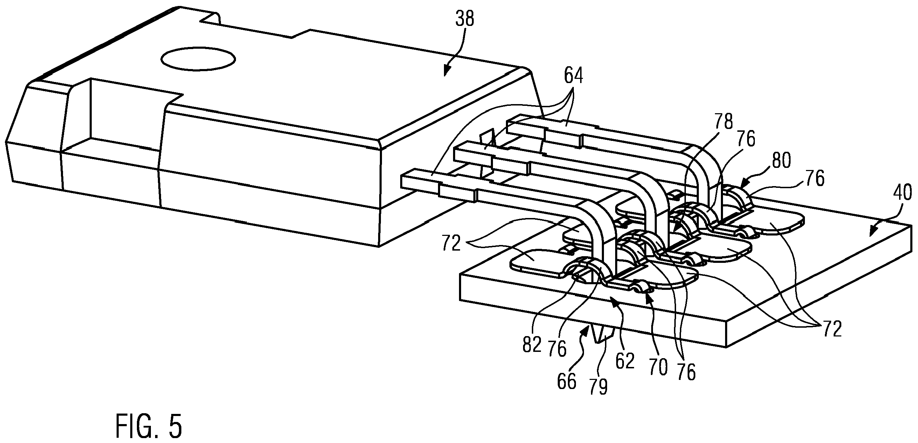

Mit Bezugszeichen 56 ist in Figur 4 ein Verdrahtungsmodul gekennzeichnet, von dem Steckerzungen 58 abragen. Das Verdrahtungsmodul 56 bildet eine Vielzahl von Steckplätzen 60 für die Steckkontaktierung der Steckerzungen 58 aus. Die bestückte Leiterplatte 40 bildet Steckplätze 60 für die Steckkontaktierung der Leistungsschalter 38 aus, die in Figur 5 im Detail gezeigt sind. Die bestückte Leiterplatte 40 bildet ferner Steckplätze 60 für die Steckkontaktierung der Steckerzungen 58 aus.

Dazu können die jeweiligen Leiterplatten 40, 56 Anschlussstücke 62 aufweisen, wie sie in den Figuren 5 bis 8 im Detail zu erkennen sind, auf die nachfolgend näher eingegangen werden wird.

Die Figur 5 zeigt den Leistungsschalter 38, der drei Pins 64 hat. Die Pins 64 durchragen eine Ausnehmung 66, die in der bestückten Leiterplatte 40 ausgespart ist. Ein einzelner Pin 64 ist über eines der Anschlussstücke 62 elektrisch leitend mit der Leiterplatte 40 verbunden.

In der Leiterplatte 40 sind auf gegenüberliegenden Seiten in Bezug auf die Öffnung 66 Befestigungslöcher 70 ausgespart. Das Anschlussstücke 62 hat zwei Befestigungsabschnitte 72, die jeweils eine ebene Anlagefläche zu der Leiterplatte 40 ausbilden. Von diesen Befestigungsabschnitten 72 ragen Haltestege 74 im Wesentlichen rechtwinklig ab und in eines der jeweiligen Befestigungslöcher 70 hinein. Zwischen den Befestigungsabschnitten 72 wird die Leiterplatte 40 von zwei durch das Anschlussstück 62 gebildete Bögen 76 überragt, die zwischen sich eine Einbringöffnung 78 für eine Kontaktzunge 79 freilassen, die durch das freie Ende eines Pins 64 gebildet ist.

Die zwei Bögen 76 fungieren auch als Verbindungsabschnitte 80, die die beiden Befestigungsabschnitte 72 miteinander verbinden. Ersichtlich ist das Anschlussstück 62 durch Stanzen und Biegen eines zunächst ebenen Blechteils gebildet. Zwischen den beiden Bögen 76 bildet das Anschlussstück 62 Federzungen 82 aus, die in die Ausnehmung 66 in an sich bekannter Weise hineinragen; vergleiche EP 2 236 330 A1. Diese Federzungen 82 sind durch Stanzen gegenüber den die Bögen 76 ausbildenden Stegen des zunächst ebenen Blechmaterials freigeschnitten. Die Bögen 76 sind konvex weg von der Leiterplatte 40 gebogen. Die Federzungen 82 sind in entgegengesetzter Richtung gebogen und überragen die ebene Anlagefläche der Befestigungsabschnitte 72 in Richtung auf die Leiterplatte 40. Die einander gegenüberliegenden, außen konvex gebogenen Oberflächen der Federzungen 82 bilden eine trichterförmige Öffnung für die Kontaktzunge 79 aus.

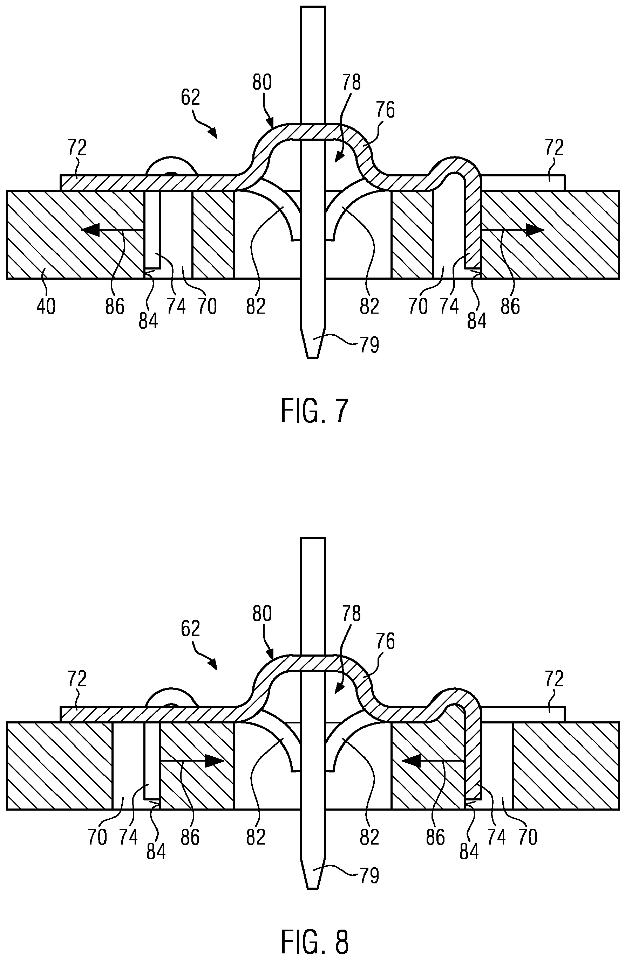

Wie den Figuren 7 und 8 zu entnehmen ist, bewirken diese Bögen 76 eine elastische Vorspannkraft, welche die Haltestege 74 elastisch gegen mit Bezugszeichen 84 gekennzeichnete Innenwände der entsprechenden Befestigungslöcher 70 drängt.

Die übliche Fallgestaltung ist in Figur 7 dargestellt. Bei dieser bewirkt die durch die Bögen 32 erzeugte elastische Vorspannkraft eine kraftschlüssige Anlage der Haltestege 74 gegen Innenwände 84 der Befestigungslöcher 70. Figur 7 verdeutlicht mit Bezugszeichen 86 die Kraftwirkungsrichtung der entsprechenden Haltekraft. Die Federvorspannung drängt die Haltestege 74 voneinander weg. Die von den Federzungen 82 beim Einbringen der Kontaktzunge 79 bewirkte Federkraft verstärkt diese kraftschlüssige Anlage der Haltestege 74 in den Befestigungslöchern 70. So ergibt sich eine dauerhaft sichere formschlüssige Klemmung des Anschlussstücks 62 in den beiden Befestigungslöchern 70 der Leiterplatte 40.

Aber auch bei der Lösung nach Figur 8 kann eine hinreichende Klemmkraft bewirkt werden, auch wenn die durch das Einbringen der Kontaktzunge 79 zwischen die Federzungen 82 vermindert wird.

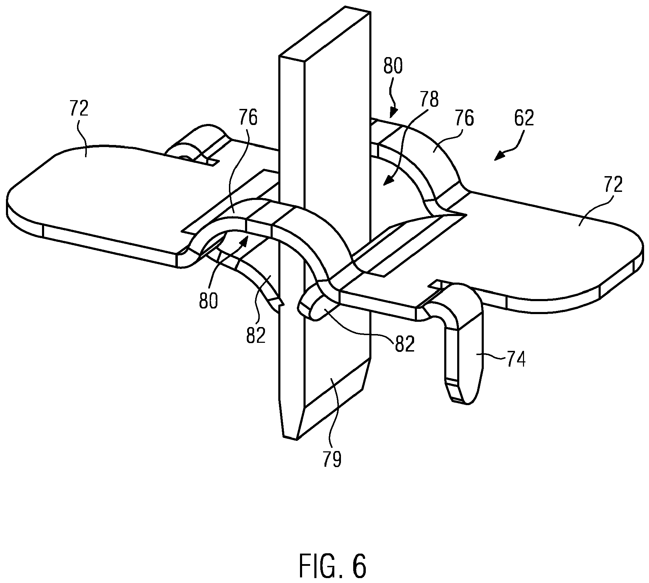

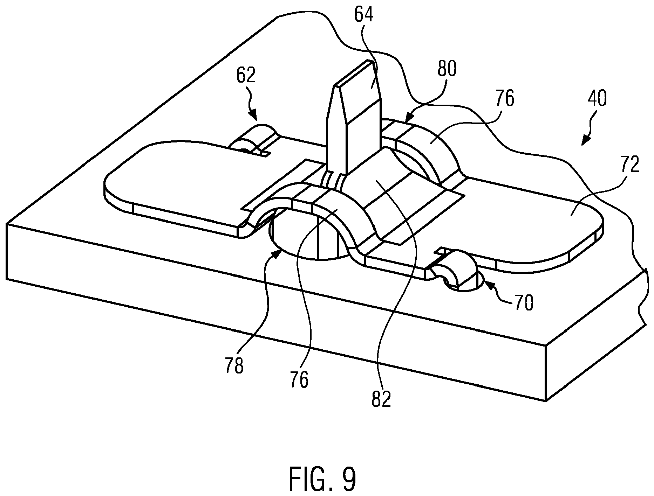

Die Figur 9 zeigt eine gegenüber den Figuren 6 bis 8 abgewandelte Ausgestaltung. Bei dieser bilden die Federzungen 82 wie zuvor eine leicht trichterförmige Öffnung für die Pins 64 des Leistungsschalters 38. Allerdings führen die Pins 64 zunächst durch die Leiterplatte 40 hindurch und sind erst danach elektrisch mit dem Anschlussstück 62 kontaktiert.

### Bezugszeichenliste

- 2: Gehäuse
- 4: Gehäuseoberteil
- 6: Gehäuseunterteil
- 8: Heizkammer
- 10: Gehäusedeckel
- 12: Trennwand
- 14: Anschlusskammer
- 16: Einlassstutzen
- 18: Auslassstutzen
- 20: Heizrippe
- 22: Aufnahmetasche
- 23: elektrische Heizeinrichtung
- 24: PTC-Heizeinrichtung
- 26: Rahmen
- 28: PTC-Element
- 30: Kontaktblech
- 32: Kontaktzungen
- 34: Isolierlage
- 36: Kühlfläche
- 38: Leistungsschalter
- 40: bestückte Steuerleiterplatte
- 42: Kühlfläche
- 44: Steuervorrichtung
- 46: Kühlrippe
- 50: Leistungsstecker
- 52: Steuerstecker
- 54: Steckkontaktelement
- 56: Verdrahtungsmodul
- 58: Steckerzunge
- 60: Steckplatz
- 62: Anschlussstück
- 64: Pin
- 66: Ausnehmung
- 70: Befestigungsloch
- 72: Befestigungsabschnitt
- 74: Haltesteg
- 76: Bogen
- 78: Einbringöffnung
- 79: Kontaktzunge
- 80: Verbindungsabschnitt
- 82: Federzungen
- 84: Innenwand
- 86: Kraftwirkungsrichtung

## Patentansprüche

1. Elektrische Heizvorrichtung, insbesondere für ein Kraftfahrzeug, mit wenigstens einer elektrischen Heizeinrichtung (23) und einer Leiterplatte (40), welche zum elektrischen Anschluss der elektrischen Heizeinrichtung (23) elektrisch leitend mit zumindest einem Anschlussstück (62) verbunden ist, das zumindest einen auf der Leiterplatte (40) anliegenden Befestigungsabschnitt (72) ausbildet, von dem wenigstens zwei Haltestege (74) abragen, die jeweils in einem an der Leiterplatte (40) ausgesparten Befestigungsloch (70) im Eingriff sind, **dadurch gekennzeichnet dass** das Anschlussstück (62) zumindest zwei über einen Verbindungsabschnitt (80) elastisch miteinander verbundene Befestigungsabschnitte (72) ausbildet, die jeweils einen der Haltestege (74) aufweisen, und derart vorgespannt ist, dass die Haltestege (74) der Befestigungsabschnitte (72) mit entgegen gerichteten Haltekräften (86) gegen eine Innenwand (84) des ihnen zugeordneten Befestigungsloches (70) wirken.

2. Elektrische Heizvorrichtung nach Anspruch 1, **dadurch gekennzeichnet, dass** die Haltestege (74) gegen jeweils eine Innenwand (84) der Befestigungslöcher (70) wirken.

3. Elektrische Heizvorrichtung nach Anspruch 1 oder 2, **dadurch gekennzeichnet, dass** der Verbindungsabschnitt (80) zumindest teilweise bogenförmig ausgebildet ist.

4. Elektrische Heizvorrichtung nach einem der Ansprüche 1 bis 3, **dadurch gekennzeichnet, dass** die Leiterplatte (40) wenigstens eine Ausnehmung (66) und das Anschlussstück (62) zumindest zwei an gegenüberliegenden Seiten in die Ausnehmung (66) hineinragende Federzungen (82) ausbildet, wobei sich zumindest zwei Federzungen (82) genau gegenüberliegen.

5. Elektrische Heizvorrichtung nach Anspruch 4, **dadurch gekennzeichnet, dass** die Federzungen (14) zwischen zwei Bögen (76) in die Ausnehmung (66) hineinragen.

6. Elektrische Heizvorrichtung nach einem der Ansprüche 1 bis 5, **dadurch gekennzeichnet, dass** das Anschlussstück (62) einstückig aus einem stanz- und biegebearbeitetem Blechstück ausgebildet ist.

7. Elektrische Heizvorrichtung nach einem der Ansprüche 1 bis 6, **dadurch gekennzeichnet, dass** die elektrischen Heizeinrichtung (23) als PTC-Heizeinrichtung (24) mit zumindest einem PTC-Element (28) und Kontaktblechen (30) zur Bestromung des PTC-Elements (28) mit unterschiedlicher Polarität ausgebildet ist.

8. Elektrische Heizvorrichtung nach einem der Ansprüche 1 bis 6, **dadurch gekennzeichnet, dass** die elektrischen Heizeinrichtung (23) als Dickschicht-Heizeinrichtung ausgebildet ist.

9. Anordnung aus einer Leiterplatte (40) und einem Anschlussstück (62), wobei die Leiterplatte (40) elektrisch leitend mit dem Anschlussstück (62) verbunden ist, das zumindest einen auf der Leiterplatte (40) anliegenden Befestigungsabschnitt (72) ausbildet, von dem wenigstens zwei Haltestege (74) abragen, die jeweils in einem an der Leiterplatte (40) ausgesparten Befestigungsloch (70) im Eingriff sind, **dadurch gekennzeichnet dass** das Anschlussstück (62) zumindest zwei über einen Verbindungsabschnitt (80) elastisch miteinander verbundene Befestigungsabschnitte (72) ausbildet, die jeweils einen der Haltestege (74) aufweisen, und derart vorgespannt ist, dass die Haltestege (74) der Befestigungsabschnitte (72) mit entgegen gerichteten Haltekräften (86) gegen eine Innenwand (84) des ihnen zugeordneten Befestigungsloches (70) wirken.

10. Anordnung nach Anspruch 9, **dadurch gekennzeichnet, dass** der Haltesteg (74) elektrisch mit der Leiterplatte (40) verbunden ist.
